# EUROPEAN PATENT APPLICATION

(11) **EP 1 876 650 A1**
(43) Date of publication of application: **09.01.2008**
(21) Application number: 06731376.7
(22) Date of filing: 07.04.2006
(51) Int. Cl.: H01L 31/04, H01L 21/223, H01L 21/225

(54) **SOLAR CELL MANUFACTURING METHOD AND SOLAR CELL**

(30) Priority: 26.04.2005 JP 2005127898
(71) Applicant: Shin-Etsu Handotai Co., Ltd, Tokyo (JP); Shin-Etsu Chemical Company, Ltd., Tokyo 100-0004 (JP)
(72) Inventor: Ohtsuka,H. Isobe R&D Ctr,Shin-Etsu Handotai Co Ltd, Annaka-shi, Gunma; 3790196 (JP); Ishikawa,N Isobe R&D Ctr,Shin-Etsu Jandotai Co Ltd, Annaka-shi, Gunma; 3790196 (JP); Takahashi, Masatoshi c/o Isobe R & D Center, Annaka-shi, Gunma; 3790196 (JP)
(74) Representative: Wibbelmann, Jobst
(86) International application number: PCT/JP2006/307429
(87) International publication number: WO 2006/117975

(57) **Abstract**

The present invention is a method for manufacturing a solar cell by forming a pn junction in a semiconductor substrate having a first conductivity type to manufacture a solar cell, including at least: applying a first coating material containing a dopant onto the semiconductor substrate having the first conductivity type; and performing vapor-phase diffusion heat treatment to form a first diffusion layer in a region applied with the first coating material and a second diffusion layer, which is formed next to the first diffusion layer through vapor-phase diffusion, with a conductivity lower than a conductivity of the first diffusion layer at the same time, and provides a solar cell. Hence, it is possible to provide a method for manufacturing a solar cell, which can manufacture a solar cell at a low cost in a simple and easy way while suppressing surface recombination in a light-receiving surface other than an electrode region and recombination in an emitter to increase photoelectric conversion efficiency of the solar cell, and a solar cell.

## Description

### TECHNICAL FIELD

The present invention relates to a method for manufacturing a solar cell and a solar cell, and more specifically to a method for manufacturing a solar cell at a low cost with high efficiency, and a solar cell manufactured with this method.

### BACKGROUND ART

Nowadays, how to reduce a cost is an important issue in a method used for manufacturing a solar cell for consumer use. To that end, a method that combines a thermal diffusion method and a screen printing method has been generally employed. A detailed description thereof is given below by way of example.

First, a single-crystal silicon ingot pulled up with a Czochralski (CZ) method or a polycrystalline silicon ingot manufactured through casting is sliced with a multi-wire process to thereby prepare a p-type silicon substrate. Next, slice damage on the substrate surface is removed with an alkaline solution. After that, the surface is given microscopic unevenness (texture) with the maximum height of about 10 µm, and an n-type diffusion layer is formed by a thermal diffusion method. In addition, TiO₂ or SiN is deposited with a film thickness of about 70 nm on a light-receiving surface to form an anti-reflection film. Next, a material mainly containing aluminum is printed throughout the back side of the light-receiving surface and then subjected to firing to thereby form a back electrode. On the other hand, a light-receiving surface side electrode is formed by printing a material mainly containing silver into a comb-like shape with a width of, for example, about 100 to 200 µm and firing the material.

This method is advantageous in that various effects that enhance characteristics are concomitantly obtained albeit the minimum necessary number of steps necessary for fabricating a device. For example, the thermal diffusion has an effect of increasing a diffusion length of minority carries in a bulk due to its gettering action. Further, upon firing the aluminum material printed on the back side, a p⁺ type high-concentration layer that serves as a BSF (Back Surface Field) layer is formed on the back side together with the electrode. Moreover, the anti-reflection film has an effect of lowering a recombination speed of carriers generated in the vicinity of the silicon surface as well as an optical effect (effect of reducing a reflectivity).
Owing to the above-described minimum number of steps and several beneficial effects, a cost for a solar cell for consumer use becomes lower than before.

However, this method could not improve conversion efficiency any more. For example, conversion efficiency of a solar cell using a single-crystal silicon substrate peaks out at about 16%. This is because dopant such as phosphorus in a diffusion layer should have a surface concentration of about 2.0 to 3.0 x 10²⁰cm⁻² to minimize a contact resistance of the light-receiving surface side electrode. If the surface concentration is high as above, a surface level becomes very high, so carrier recombination is promoted near the light-receiving surface, a short-circuit current and an open-circuit voltage are limited, and conversion efficiency peaks out.

To that end, there has been proposed a method of reducing a surface concentration of a diffusion layer at a light-receiving surface to improve conversion efficiency by use of the above method that combines the thermal diffusion method and the screen printing method. For example, the invention pertinent to this method has been known as disclosed in the specification of United States Patent No. 6180869. According to this publication, a low ohmic contact can be formed even with the diffusion-layer surface concentration of about 1.0 x 10²⁰cm⁻² or lower. This is because a compound containing a dopant is added around a silver filler in an electrode paste. Thus, the dopant forms a high-concentration layer just below the electrode upon firing the electrode.
However, the above method of adding the dopant-contained compound around the silver filler in the electrode paste involves a problem in that a fill factor is low and reliability is low because a contact cannot be formed with stability.

Further, "a photoelectric conversion device and a method for manufacturing the same" as disclosed in Japanese Unexamined Patent Application Publication No. 2004-273826 has been known, for example, as a method of forming a high-concentration diffusion layer (emitter layer) containing a dopant in a high concentration only just below an electrode to lower a surface concentration of a diffusion layer in the other region of the light-receiving surface, that is, forming a two-stage emitter structure to improve conversion efficiency. This method is accomplished by changing a known method of forming an electrode in an embedded electrode type solar cell as disclosed in Japanese Unexamined Patent Application Publication Nos. Hei 8-37318 and Hei 8-191152 from electrolytic plating to screen printing. This method facilitates manufacturing control and reduces a manufacturing cost.
However, this manufacturing method for an embedded electrode type solar cell requires at least two diffusion steps and thus is complicated, resulting in a high cost.

As another example of the method of forming a two-stage emitter structure to improve conversion efficiency, "a method for manufacturing a solar cell" (Japanese Unexamined Patent Application Publication No. 2004-221149) is known, for instance. Proposed in this publication is that plural types of coating materials are applied by an ink-jet method at the same time to form plural regions containing different kinds of dopants in different dopant concentrations through simple steps.
However, in the case of manufacturing a solar cell through dopant application with the ink-jet method, if a dopant is a phosphoric acid or the like, it is necessary to take a corrosion countermeasure, so a device is complicated and troublesome maintenance is required.

Further, as another example of the method of forming a high-concentration diffusion layer only just below an electrode to lower a surface concentration of a diffusion layer in the other regions of a light-receiving surface to increase conversion efficiency, "a method for manufacturing a solar cell" (Japanese Unexamined Patent Application Publication No. 2004-281569) is known, for example.
However, this method requires two heat treatment steps as described in the specification of Japanese Unexamined Patent Application Publication No. 2004-281569 and thus is not simple. However, if the heat treatment step is performed only once, a dopant concentration is increased even in the regions of the light-receiving surface other than the region just below the electrode as a result of auto-doping, and high conversion efficiency cannot be attained.

### DISCLOSURE OF INVENTION

The present invention has been accomplished in view of the above problems, and it is accordingly an object of the present invention to provide a method for manufacturing a solar cell, which can manufacture a solar cell at a low cost in a simple and easy way while suppressing surface recombination in a light-receiving surface other than an electrode region and recombination in an emitter to increase photoelectric conversion efficiency of the solar cell, and a solar cell.

To attain the above object, the present invention provides a method for manufacturing a solar cell by forming a pn junction in a semiconductor substrate having a first conductivity type to manufacture a solar cell, including at least: applying a first coating material containing a dopant onto the semiconductor substrate having the first conductivity type; and performing vapor-phase diffusion heat treatment to form - a first diffusion layer in a region applied with the first coating material and a second diffusion layer, which is formed next to the first diffusion layer through vapor-phase diffusion, with a conductivity lower than a conductivity of the first diffusion layer at the same time.

As described above, the first coating material containing a dopant is applied onto the semiconductor substrate having the first conductivity type, and vapor-phase diffusion heat treatment is performed to form the first diffusion layer in a region applied with the first coating material and the second diffusion layer, which is formed next to the first diffusion layer through vapor-phase diffusion, with a conductivity lower than a conductivity of the first diffusion layer at the same time. This facilitates a complicated process for forming a two-stage emitter structure composed of a high-concentration diffusion layer and a low-concentration diffusion layer, such as a process for forming a diffusion mask, with the result that a manufacturing cost is reduced. In addition, since a sufficient surface concentration is kept in the first diffusion layer as a high-concentration region, a low ohmic contact is easily attained, and a high-performance solar cell can be manufactured with no variation in performance while keeping a high production yield.

Further, the present invention provides a method for manufacturing a solar cell by forming a pn junction in a semiconductor substrate having a first conductivity type to manufacture a solar cell, including at least: applying a second coating material containing a dopant onto the semiconductor substrate having the first conductivity type; and performing vapor-phase diffusion heat treatment to form a second diffusion layer in a region applied with the second coating material and a first diffusion layer, which is formed next to the second diffusion layer through vapor-phase diffusion, with a conductivity higher than a conductivity of the second diffusion layer at the same time.

As described above, if a high-concentration diffusion layer is formed through vapor-phase diffusion and a low-concentration diffusion layer is formed through coating diffusion, also, a low-cost and high-performance solar cell can be manufactured at a high yield with no variation in performance.

Further, it is preferred that the first coating material or the second coating material contains a silicon compound.
As described above, if the first coating material or the second coating material contains a silicon compound, out-diffusion (external diffusion) of dopants can be suppressed to thereby ensure a surface concentration difference between the high-concentration diffusion layer and the low-concentration diffusion layer in the two-stage emitter structure.

Further, it is preferred that the silicon compound be silica gel or a precursor of silicon oxide.
As described above, if the silicon compound is silica gel or a precursor of silicon oxide such as alkoxysilane, a viscosity of the coating material can be effectively controlled, and out-diffusion of dopants can be suppressed to thereby ensure a surface concentration difference between the high-concentration diffusion layer and the low-concentration diffusion layer in the two-stage emitter structure.

Moreover, it is preferred that a third coating material containing a silicon compound be applied over the first coating material or the second coating material and then the diffusion heat treatment be performed.
As described above, if the third coating material containing a silicon compound is applied over the first coating material or the second coating material and then the diffusion heat treatment is performed, out-diffusion and auto-doping can be further suppressed to thereby ensure a surface concentration difference between the high-concentration diffusion layer and the low-concentration diffusion layer in the two-stage emitter structure.

Further, it is preferred that a surface of a diffusion layer formed through the diffusion heat treatment be etched back.
As described above, if the surface of the diffusion layer formed through the diffusion heat treatment is etched back, a region having many surface levels in the low-concentration diffusion layer is particularly etched, so a performance of the solar cell can be improved.

Further, it is preferred that a surface of a diffusion layer formed through the diffusion heat treatment be oxidized.
As described above, even if the surface of the diffusion layer formed through the diffusion heat treatment is oxidized, a region having many surface levels is etched in a subsequent glass etching step, so a performance of the solar cell can be improved.

Further, the first diffusion layer and the second diffusion layer can be formed on at least one of a light-receiving surface of the semiconductor substrate and a back side of the light-receiving surface.
As described above, if the first diffusion layer and the second diffusion layer are formed on at least one of the light-receiving surface of the semiconductor substrate and the back side of the light-receiving surface, a solar cell with a conventional structure can be easily manufactured, and a BSF layer can be easily formed on all or part of the back side.

Further, the present invention provides a solar cell manufactured with the above manufacturing method, including: the first diffusion layer having a conductivity type opposite to a first conductivity type of the semiconductor substrate; and the second diffusion layer with a conductivity lower than a conductivity of the first diffusion layer having the opposite conductivity type, the first diffusion layer and the second diffusion layer being formed on a light-receiving surface of the semiconductor substrate.

As described above, if the first diffusion layer having a conductivity type opposite to a first conductivity type of the semiconductor substrate and the second diffusion layer with a conductivity lower than a conductivity of the first diffusion layer having the opposite conductivity type are formed on the light-receiving surface of the semiconductor substrate, a low-cost, high-production-yield, and high-performance solar cell having a two-stage emitter structure can be obtained.

In this case, it is preferred that at least a diffusion layer having the same conductivity type as the first conductivity type be formed on a back side of the light-receiving surface.
As described above, if at least a diffusion layer having the same conductivity type as the first conductivity type is formed on the back side of the light-receiving surface, a solar cell having a BSF layer formed on all or part of the back side is obtained.

The method for manufacturing a solar cell according to the present invention facilitates a complicated process for forming a two-stage emitter structure composed of a high-concentration diffusion layer and a low-concentration diffusion layer, such as a process for forming a diffusion mask, with the result that a manufacturing cost is reduced. In addition, since a sufficient surface concentration is kept in the first diffusion layer as a high-concentration region, a low ohmic contact is easily attained, and a high-performance solar cell can be manufactured with no variation in performance while keeping a high production yield.

Further, the solar cell according to the present invention is a low-cost, high-production-yield, and high-performance solar cell having a two-stage emitter structure.

### BRIEF DESCRIPTION OF DRAWINGS

FIG. 1 shows a sectional structure of an example of a solar cell according to an embodiment of the present invention;
FIG. 2(a) is a flow chart of a method for manufacturing a solar cell according to a first embodiment of the present invention, and FIG. 2(b) is a flow chart of an example of a method for manufacturing a conventional solar cell that forms a two-stage emitter structure by use of a mask;
FIGS. 3 are explanatory views for illustrating the method for manufacturing a solar cell of FIG. 2(a);
FIG. 4 shows an anti-reflection structure (random texture) of a single-crystal solar cell;
FIG. 5 is an explanatory view for illustrating a method for manufacturing a solar cell according to a second embodiment of the present invention;
FIGS. 6 show a sectional structure of another example of the solar cell according to the embodiment of the present invention; and
FIG. 7 shows external quantum efficiency of Examples 2, 3, and 4.

### BEST MODE(S) FOR CARRYING OUT THE INVENTION

Hereinafter, embodiments of the present invention will be described in detail, but the present invention is not limited to these embodiments.

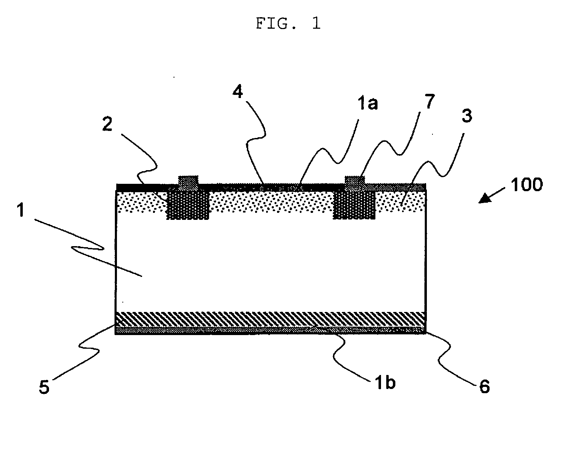

FIG. 1 shows a sectional structure of an example of a solar cell according to an embodiment of the present invention.
A solar cell 100 is structured such that a high-concentration emitter layer 2 as a first diffusion layer having a conductivity type opposite to a first conductivity type of a semiconductor substrate 1 and a low-concentration emitter layer 3 as a second diffusion layer with a conductivity lower than that of the high-concentration emitter layer 2 are formed on a light-receiving surface 1a of the semiconductor substrate. Preferably, a BSF layer 5 as a diffusion layer having the at least same conductivity type as the first conductivity type is formed on a back side 1b of the light-receiving surface.

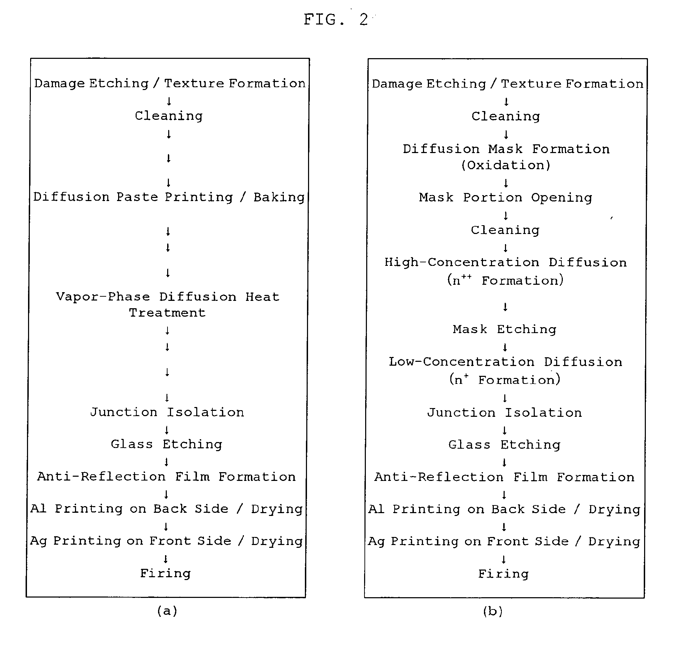

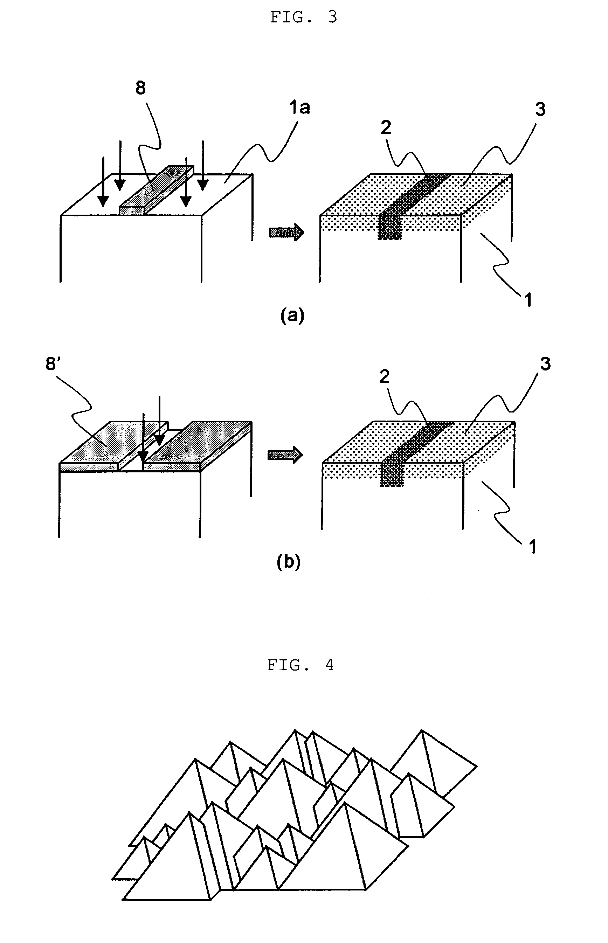

A solar cell manufacturing flow of FIG. 1 is described hereinbelow. FIG. 2(a) is a flow chart of a method for manufacturing a solar cell according to a first embodiment of the present invention, and FIG. 2(b) is a flow chart of an example of a method for manufacturing a conventional solar cell that forms a two-stage emitter structure by use of a mask. FIGS. 3 are explanatory views for illustrating the method for manufacturing a solar cell of FIG. 2(a)

First, the semiconductor substrate 1 of the first conductivity type is prepared. Although characteristics of the semiconductor substrate 1 are not particularly limited, a gallium-doped single-crystal silicon substrate having a p-type conductivity as the first conductivity type can be used, which shows crystal orientation in the direction of (100) plane, measures 15 cm per side, and has a thickness of 250 µm and a resistivity of 2 Ω·cm in an as-sliced state (dopant concentration of 7.2 x 10¹⁵ cm⁻³), for instance. This substrate is immersed in, for example, a 40-wt% aqueous sodium hydroxide solution, and a damaged layer is removed through etching. The substrate 1 may be manufactured with either a CZ method or a floating zone (FZ) method. A resistivity of the substrate is preferably 0.1 to 20 Ω·cm, more preferably 0.5 to 2.0 Ω·cm from the viewpoint of manufacturing a high-performance solar cell. In addition, in the above example, the damaged layer of the substrate 1 is removed with an aqueous sodium hydroxide solution but may be removed with a strong alkaline aqueous solution such as an aqueous potassium hydroxide solution. Alternatively, an acid aqueous solution such as an aqueous solution of hydrofluoric-nitric acid fits the purpose.

In general, a solar cell preferably has microscopic unevenness on its surface because a light-receiving surface needs to reflect light twice or more as much as possible to reduce reflectivity of light in a visible light range. For that purpose, the substrate subjected to etching for removing a damaged portion is immersed in an aqueous solution prepared by adding isopropylalcohol to a 3-wt% aqueous sodium hydroxide solution for wet etching to thereby obtain a random texture as shown in FIG. 4 on both sides. Each hill has a size of about 1 to 20 µm. To give another typical example of such uneven structures, a V-groove and a U-groove are known. These grooves can be formed by means of a grinding machine. Further, acid etching or reactive ion etching may be alternatively performed to obtain a randomly uneven structure. Incidentally, the texture structure formed on both sides of the substrate (the light-receiving surface 1a and the back side 1b) is a fine structure and thus omitted from FIG. 1.

Subsequently, after the completion of cleaning the substrate, as shown in FIG. 3(a), a diffusion paste 8 containing a dopant such as a phosphoric acid and preferably, a silicon compound such as a silica gel or a precursor of silicon oxide which is, for example, alkoxysilane and the like is printed and applied as a first coating material onto the light-receiving surface 1a of the substrate by a screen printing equipment. At this time, the paste may be printed into a stripe-shaped line pattern or a dot pattern. As for the printing pattern for a line pattern, 150 µm-wide lines may be formed at 2 mm pitches. The printed substrate is backed at 700°C for 30 minutes. After that, the thus-prepared sample substrate is put into an annealing furnace and held under a vapor-phase diffusion source atmosphere such as POCl₃ at 880°C for 30 minutes for vapor-phase diffusion heat treatment and then taken out. As a result, it is possible to form a first diffusion layer 2 (also referred to as a high-concentration diffusion layer or high-concentration emitter layer) which is formed through coating and a second diffusion layer 3 (also referred to as a low-concentration diffusion layer or low-concentration emitter layer), which is formed through vapor-phase diffusion and has a conductivity lower than the first diffusion layer, at the same time, and a pn junction is formed. A sheet resistance of a region other than the diffusion-paste-printed portion as the low-concentration emitter layer, that is, a region subjected to only vapor-phase diffusion may be set to 80 to 110 Ω/□. In addition, a surface concentration of dopants in the diffusion-paste-printed portion may be set to about 2 x 10²⁰ cm⁻².

Incidentally, as another embodiment, as shown in FIG. 3(b), the same process as the above is performed, except that a diffusion paste 8' having a dopant concentration lower than that of the first coating material is printed and applied as a second coating material onto the light-receiving surface 1a of the substrate and a high-concentration vapor-phase diffusion source is used in a subsequent step. Then, the vapor-phase diffusion heat treatment may be performed to form the second diffusion layer through coating and the first diffusion layer with a conductivity higher than that of the second diffusion layer through vapor-phase diffusion at the same time.
In this case, the silicon compound such as silica gel in the diffusion paste 8' for forming the low-concentration emitter layer 3 functions to suppress out-diffusion of dopants from the paste and prevent dopants of the vapor-phase diffusion source from diffusing to the low-concentration emitter layer 3. This fabrication method has a feature that a two-stage emitter structure can be formed with reliability.

Subsequently, junction isolation is performed with a plasma etcher. In this process, a plurality of sample substrates are stacked so as for plasma and radicals not to enter into the light-receiving surface 1a and the backside 1b, and a substrate end surface thereof is removed by several micrometers as they are.

Subsequently, phosphosilicate glass formed on the surface is etched with a hydrofluoric acid. Then, a direct plasma CVD apparatus with a frequency of 13.56 MHz is used to deposit a nitride film, for example, as a surface protective film (passivation film)/anti-reflection film 4 on the emitter layer as shown in FIG. 1. This passivation film/anti-reflection film 4 doubles as an anti-reflection film, so its film thickness is preferably 70 nm to 100 nm. Other alternative examples of the anti-reflection film include an oxide film, a titanium dioxide film, a zinc oxide film, and a tin oxide film. Further, as the formation method, a remote plasma CVD method, a coating method, a vacuum deposition method, and the like can be also used as well as the above method. It is preferred to form a nitride film by the plasma CVD method as above from an economical viewpoint. Moreover, if a film that meets such conditions that the total reflectivity is minimized, for example, a film having a refractive index of 1 to 2 such as a magnesium difluoride film is formed on the anti-reflection film, a reflectivity is further reduced, and a generated-current density is increased.

Next, a paste containing, for example, aluminum is applied onto the back side 1b with the screen printing equipment or the like and then dried. Further, an 80 µm-wide Ag electrode is printed also to the light-receiving surface 1a with a comb-like electrode pattern printing plate by the screen printing equipment or the like and is then dried, for example. At this time, the printing is performed such that the comb-like electrode is placed on the high-concentration emitter layer 2 by utilizing an alignment mechanism. Conceivable examples of the alignment include a method of determining an electrode position directly from a color of a high-concentration diffusion layer and a method of previously placing marks on the substrate and printing a diffusion pate and an electrode on the basis of the marks.

After that, firing is carried out in accordance with a predetermined heat profile to form the BSF layer 5, a back electrode 6, and a surface comb-like electrode 7. These electrodes may be formed by a method other than the above method, such as a vacuum deposition or a sputtering.

On the other hand, a solar cell manufacturing flow of a conventional method that forms a two-stage emitter structure with a mask is described with reference to FIG. 2(b).
First, similar to the first embodiment of the present invention, a semiconductor substrate such as an as-sliced gallium-doped p-type single-crystal silicon substrate having a size of 15 cm per side is prepared, followed by etching of a damaged portion and formation of random textures, for example.

After the completion of cleaning the substrate, an oxide film is formed as a diffusion mask through oxidation on the surface. The requisite thickness of the oxide film as a diffusion mask is at least 100 nm.

Subsequently, a linear opening needs to be formed in the diffusion mask to form a high-concentration diffusion layer into 2 mm-pitch line patterns. As a method of forming the opening, a target portion may be etched off with a hydrofluoric acid while the remaining portions are masked. In this example, an opening is formed by chipping off the oxide film in a line shape by means of a dicing saw. In this case, although the semiconductor substrate is partially chipped off together with the oxide film, it does not affect characteristics since the opening is near the contact.

After the completion of partially chipping off the mask to form an opening, the substrate is cleaned, and POCl₃ vapor-phase diffusion is performed such that a sheet resistance of a portion subject to the diffusion is, for example, 40 Ω/□ or less to thereby form a high-concentration diffusion layer (for example, n⁺⁺ layer). Subsequently, mask etching is carried out and then, POCl₃ vapor-phase diffusion is performed such that a sheet resistance of a portion subject to the diffusion is 100 Ω/□ over the entire light-receiving surface to thereby form a low-concentration diffusion layer (for example, n⁺ layer). In this way, a two-stage emitter structure is formed.
The next step, junction isolation, and subsequent steps are the same as those of the first embodiment as shown in FIG. 2(a).

The conventional method for manufacturing a solar cell with a two-stage structure is very traditional. However, as apparent from the comparison between the methods of FIGS. 2(a) and 2(b), the number of process steps of the manufacturing method of the present invention as shown in FIG. 2(a) is very small and thus, the method of the present invention can lower a manufacturing cost largely and is advantageous.
Further, if a diffusion paste contains silica gel or alkoxysilane, out-diffusion of dopants can be suppressed. However, in practice, the suppression of 100% in the out-diffusion of dopants is impossible; some of dopants rediffuse. However, since a sample is placed under a vapor-phase diffusion source atmosphere that is filled with dopants enough upon vapor-phase diffusion heat treatment, even if rediffusion of dopants that diffuse out of the diffusion paste occurs, a concentration of a diffusion layer can be made uniform without causing an in-plane distribution thereof, and a solar cell with little variation in performance can be provided.
In this way, the manufacturing method of the present invention can produce a competitive product on the solar cell market.

Incidentally, in the above example, if a third coating material containing a silicon compound such as silica gel is applied over the first coating material or the second coating material, followed by the diffusion heat treatment, out-diffusion and auto-doping can be further suppressed to thereby ensure a surface concentration difference between the high-concentration diffusion layer and the low-concentration diffusion layer in the two-stage emitter structure.

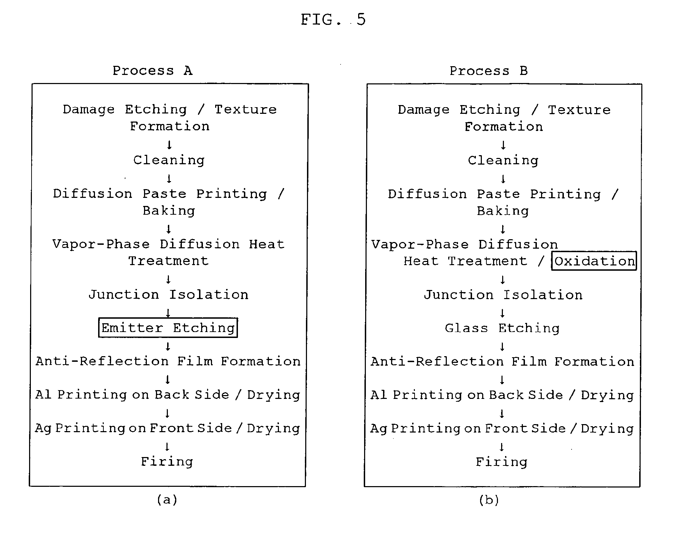

FIGS. 5 are explanatory views for illustrating a method for manufacturing a solar cell according to a second embodiment of the present invention.

In a process A of FIG. 5(a), in addition to the vapor-phase diffusion heat treatment of the manufacturing flow of FIG. 2(a), the substrate is immersed in an ammonium/hydrogen peroxide mixture after the diffusion heat treatment to etch (etch back) a portion supposed to have a high interface state density in the emitter layer as a surface layer, that is, a portion with the thickness of about several nanometers. The step of forming an anti-reflection film and subsequent steps are performed similarly to those of FIG. 2(a) to especially reduce the number of surface levels of a low-concentration diffusion layer to improve a performance of a solar cell.
Incidentally, similar effects can be attained if the surface layer is etched with a hydrofluoric-nitric acid or weak alkali instead of using the ammonium/hydrogen peroxide mixture.

Further, in a process B of FIG. 5(b), after the completion of the diffusion heat treatment in the manufacturing flow of FIG. 2(a), only dry oxygen is applied without decreasing the temperature, and the substrate is held in a furnace for 10 minutes. As a result, an uppermost region with a high interface state density is only oxidized and can be easily etched through glass etching with a dilute hydrofluoric acid after junction isolation. In this case as well, if the step of forming an anti-reflection film and subsequent steps are performed similarly to those of FIG. 2(a), it is possible to especially reduce the number of surface levels of a low-concentration diffusion layer to improve a performance of a solar cell.

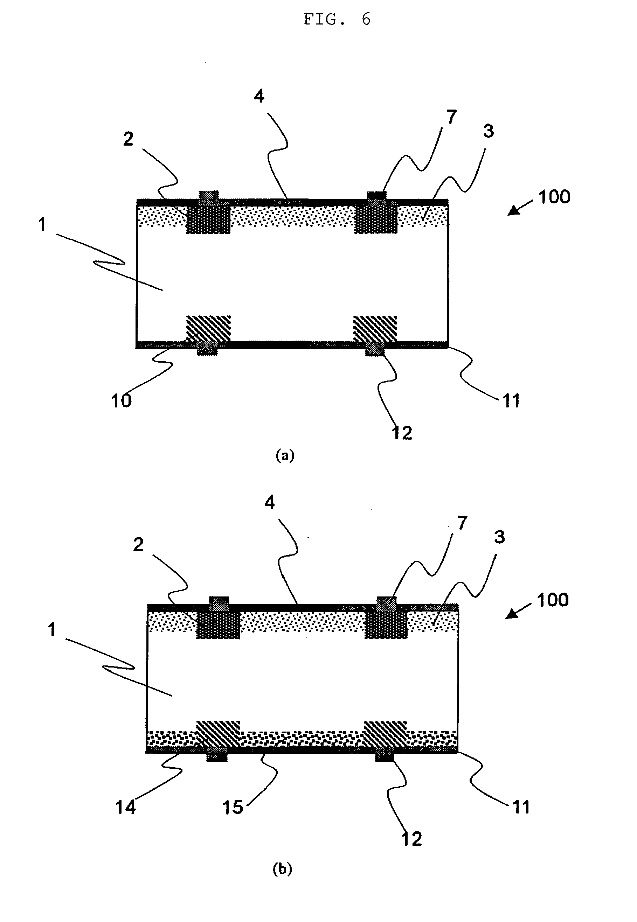

FIGS. 6 show a sectional structure of another example of the solar cell according to the embodiment of the present invention.
As shown in FIG. 1, a solar cell manufactured with a typical screen printing technique has such a structure that the back side is completely covered with the A1-attributed BSF layer 5. It is known that, if an area of the BSF layer is reduced and the remaining regions of the back side is covered with a high-quality passivation film, an open-circuit voltage increases, with the result that an output power is increased.

The solar cell of FIGS. 6 reduces an area of the BSF layer as described above. The embodiment of FIG. 6(a) (hereinafter referred to as a sample (A)) is accomplished by forming a local BSF layer 10 of the same conductivity type as that of the substrate 1 only just below a contact with a back comb-like electrode 12. The embodiment of FIG. 6(b) (hereinafter referred to as a sample (B)) is accomplished by forming a high-concentration BSF layer 14 of the same conductivity type as that of the substrate 1 only just below the back comb-like electrode 12 and forming a low-concentration BSF layer 15 of the same conductivity type as that of the substrate 1 over the back side.

A conventional technique requires a diffusion mask for forming a diffusion layer in a predetermined portion as described above, but the manufacturing method of the present invention does not require this mask and can easily provide a desired structure:
Hereinbelow, a method for manufacturing the above solar cell according to a third embodiment of the present invention is described.

First, prepared as the semiconductor substrate 1 is a gallium-doped single-crystal silicon substrate having a p-type conductivity, which shows crystal orientation in the direction of (100) plane, measures 15 cm per side, and has a thickness of 250 µm and a resistivity of 0.5 Ω·cm in an as-sliced state (dopant concentration of 3.26 x 10¹⁶ cm⁻³), for instance. A damaged portion is etched by about 30 µm in total on both sides with the same process as that of FIG. 2(a) and in addition, a texture as an anti-reflection structure is formed on the surface.

Subsequently, after the completion of cleaning the substrate, a diffusion paste is printed to a region for forming a high-concentration diffusion layer for the purpose of forming a two-stage emitter structure on the light-receiving surface side and then, the substrate is held under a vapor-phase diffusion source atmosphere such as POCl₃ at 880°C for 30 minutes to subject only the light-receiving surface side to vapor-phase diffusion heat treatment. After that, the substrate is taken out.

Next, a paste containing boron oxide as a dopant of the same conductivity type as that of the substrate 1 in a concentration of 0.1 g/ml is printed into a line pattern at 2 mm pitches with a width of 200 µm on the back side, for example. Among samples subjected to the above process, a sample that is subsequently baked at 700°C for 30 minutes and applied with a coating material containing alkoxysilane on the back side through spin-coating under the conditions of 3000 rpm and 15 seconds is referred to as a sample (A). On the other hand, among the samples subjected to the above process, a sample that is subsequently printed with a paste containing boron oxide and silica over the entire surface and backed at 700°C for 30 minutes is referred to as a sample (B).

Subsequently, these samples (A) and (B) are put in an annealing furnace and held at 980°C for 10 minutes and then taken out.
Next, after the completion of junction isolation with a plasma etcher similar to the process of FIG. 2(a), phosphosilicate or borosilicate glass on the surface is etched with a hydrofluoric acid.

After that, a direct plasma CVD equipment is used to deposit the passivation film/anti-reflection film 4 and a back passivation film 11, such as a nitride film or the like, with the thickness of, for example, 85 nm on both sides. If the back passivation film 11 is deposited into the thickness of 70 nm to 110 nm, the solar cell can be used as a double-sided light-receiving cell.

Next, an Ag-contained electrode paste is printed in proper alignment with the high-concentration diffusion layers on both sides by a screen printing equipment with an alignment mechanism to thereby form a comb-like electrode pattern. The electrode paste is dried and then subjected to firing in accordance with a predetermined heat profile to thereby manufacture a solar cell as shown in FIGS. 6.

In this embodiment, the BSF region is limited to only a region just below the contact, not the entire surface. Thus, an open-circuit voltage is considerably increased as compared with the solar cell of FIG. 1. Further, a short-circuit current is increased because an amount of light absorption near the back side is reduced. Further, a grid electrode is formed on the back side, so the substrate's warp is reduced. This means that a thin cell can be easily achieved.

In the above embodiment, a low-concentration BSF layer of the sample (B) can be formed by adjusting a dopant concentration of the diffusion paste. Alternatively, the same structure as the sample (B) can be obtained by reducing the silica gel content with no dopant to thereby cause rediffusion of dopants that diffuse out of the diffusion paste for forming the high-concentration BSF layer.
Moreover, if an oxide film is formed through oxidation with the thickness of 5 to 30 nm prior to the deposition of the anti-reflection film/passivation film such as a nitride film, an open-circuit voltage is further increased and power generation efficiency is enhanced.

Hereinafter, detailed description is given on the basis of Examples of the present invention and Comparative Examples, but the present invention is not limited thereto.

### (Examples 1 and 2 and Comparative Example 1)

As Examples 1 and 2, a gallium-doped single-crystal silicon substrate having a p-type conductivity as the first conductivity type was prepared; the substrate shows crystal orientation in the direction of (100) plane, measures 15 cm per side, and has a thickness of 250 µm and a resistivity of 2 Ω·cm in an as-sliced state (dopant concentration of 7.2 x 10¹⁵ cm⁻³). This substrate was immersed in a 40-wt% aqueous sodium hydroxide solution, and a damaged layer was removed through etching. Next, the substrate was immersed in an aqueous solution prepared by adding isopropylalcohol to a 3-wt% sodium hydroxide for wet etching to thereby obtain a random texture over the surface.

Subsequently, after the completion of cleaning the substrate, a diffusion paste containing a phosphoric acid was printed and applied onto light-receiving surfaces of a half of samples subjected to the above process by a screen printing equipment. At this time, printing patterns were 2 mm-pitch and 150 µm-width line patterns. The printed substrate was baked at 700°C for 30 minutes. Then, the thus-prepared sample substrate was put in an annealing furnace and held under a POCl₃ atmosphere at 880°C for 30 minutes for vapor-phase diffusion heat treatment and then taken out. As a result, a high-concentration emitter layer was formed in a region printed with the diffusion paste, and a low-concentration emitter layer was formed in a region subjected to only vapor-phase diffusion. The completed one is referred to as a sample (a) (Example 1).

On the other hand, a diffusion paste containing a phosphoric acid was printed and applied onto light-receiving surfaces of the remaining half by a screen printing equipment. In this case, printing patterns are not printed to regions corresponding to the line patterns of the sample (a). The printed substrate was baked at 700°C for 30 minutes. Then, the thus-prepared sample substrate was put in an annealing furnace and held under a POCl₃ atmosphere at 880°C for 30 minutes for vapor-phase diffusion heat treatment and then taken out. As a result, a low-concentration emitter layer was formed in a region printed with the diffusion paste, and a high-concentration emitter layer was formed in a region subjected to only vapor-phase diffusion. The completed one is referred to as a sample (b) (Example 2).

As a result of measuring a sheet resistance of the low-concentration emitter layer of the above samples (a) and (b), the sheet resistance was 80 to 100 Ω/□. Further, as a result of determining a diffusion profile with a spreading resistance (SR) method, a surface concentration of dopants in the high-concentration emitter layer was 2 x 10²⁰ cm⁻².

Next, junction isolation was performed with a plasma etcher, followed by etching of phosphosilicate glass formed on the surface with a hydrofluoric acid. After that, a direct plasma CVD equipment with a frequency of 13.56 MHz was used to deposit a 70 nm-thick nitride film on the emitter layer.

Next, an aluminum-contained paste was applied to the back side by a screen printing equipment or the like and dried. Further, an Ag electrode having the width of 80 µm was printed also to the light-receiving surface side with a comb-like electrode pattern printing plate by the screen printing equipment or the like and dried. At this time, the printing was performed such that the comb-like electrode overlies the high-concentration emitter layer by utilizing an alignment mechanism.
After that, firing was performed in accordance with a predetermined heat profile to form a back electrode and a surface comb-like electrode to complete a solar cell.

On the other hand, as Comparative Example 1, an as-sliced gallium-doped single-crystal silicon substrate having a p-type conductivity and a size of 15 cm per side was prepared similar to Examples 1 and 2. A solar cell was manufactured in accordance with the process of FIG. 2(b).

Under such conditions that each of the manufactured 15-cm square solar cells was placed under an atmosphere at 25°C, current-voltage characteristics were measured with a solar simulator (light intensity: 1 kW/m², spectrum: AM 1.5 global illuminance). Table 1 shows an average value of measurements and a standard deviation as a variation.

**[Table 1]**

| | Open-circuit voltage (V) | Short-circuit current density (mA/cm²) | Conversion efficiency (%) | Fill factor |
|---|---|---|---|---|
| Example 1 | 0.635 | 37.0 | 18.5 | 0.788 |
| Sample (a) | (0.45) | (0.21) | (0.15) | (0.65) |
| Example 2 | 0.631 | 36.4 | 18.3 | 0.795 |
| Sample (b) | (0.63) | (0.34) | (0.18) | (0.28) |
| Comparative | 0.638 | 36.2 | 18.2 | 0.789 |
| Example 1 | (0.88) | (0.45) | (0.31) | (0.66) |

In the table, numerical values in parentheses represent standard deviation.

As apparent from Table 1, there is no difference in performance between the solar cells of Examples 1 and 2 and the solar cells of Comparative Example 1, which were manufactured with a conventional method, although the number of process steps and manufacturing cost for the solar cells of the present invention are far less than the solar cells manufactured with the conventional method. Moreover, as apparent from the standard deviation in parentheses, the standard deviation is reduced by the manufacturing method according to the examples of the present invention. That is, variations in performance could be minimized by the method of the present invention. Hence, the method of the present invention can produce a competitive product on the solar cell market.

### (Examples 3 and 4)

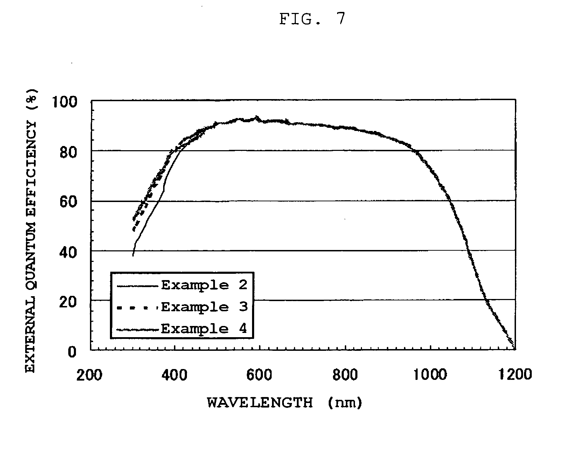

A low-concentration emitter layer was formed in a region printed with a diffusion paste and a high-concentration emitter layer was formed in a region subjected to only vapor-phase diffusion in accordance with the process A or B of FIGS. 5 to thereby manufacture a solar cell (Examples 3 and 4). Various characteristics of the solar cell manufactured in these examples are summarized in Table 2. Incidentally, various characteristics of the solar cell of Example 2 are added for comparative purposes. In addition, spectral sensitivity characteristics (external quantum efficiency) are shown in FIG. 7.

**[Table 2]**

| | Open-circuit voltage (V) | Short-circuit current density (mA/cm2) | Conversion efficiency (%) | Fill factor |
|---|---|---|---|---|
| (Process A) | 0.634 | 36.9 | 18.5 | 0.789 |
| (Process B) | 0.635 | 37.2 | 18.4 | 0.778 |
| Example 2 | 0.631 | 36.4 | 18.3 | 0.795 |

Both of the samples of Examples 3 and 4 subjected to the process A or B show larger values in both of the short-circuit current and the open-circuit voltage than the sample of Example 2, an emitter layer of which was not etched back. However, a surface concentration is slightly lowered at the contact portion, so a fill factor is decreased.
The short-circuit current is increased because quantum efficiency of a short-wavelength range is increased after the emitter layer is etched back as shown in FIG. 7. As in these examples, the surface portion of the diffusion layer is modified to thereby reduce the interface state density to further improve a performance of the solar cell.

### (Examples 5 and 6)

A solar cell as shown in FIGS. 6(a) and (b) was manufactured.
To be specific, a gallium-doped single-crystal silicon substrate having a p-type conductivity was prepared; the substrate shows crystal orientation in the direction of (100) plane, measures 15 cm per side, and has a thickness of 250 µm and a resistivity of 0.5 Ω·cm in an as-sliced state (dopant concentration of 3.26 x 10¹⁶ cm⁻³). A damaged portion was etched by about 30 µm in total on both sides with the same process as that of FIG. 2(a) to form a texture as an anti-reflection structure on the surface.

Subsequently, after the completion of cleaning the substrate, a diffusion paste was printed to a region for forming a high-concentration diffusion layer for the purpose of forming a two-stage emitter structure on the light-receiving surface side in the same way as that of FIG. 2(a) and then, the substrate was held under a POCl₃ vapor-phase diffusion source atmosphere at 880°C for 30 minutes to subject only the light-receiving surface side to vapor-phase diffusion heat treatment. After that, the substrate was taken out.

Next, a paste containing boron oxide in a concentration of 0.1 g/ml was printed into a line pattern at 2 mm pitches with a width of 200 µm on the back side. Among samples subjected to the above process, a half of samples that are subsequently baked at 700°C for 30 minutes and applied with a coating material containing alkoxysilane on the back side through spin-coating under the conditions of 3000 rpm and 15 seconds are referred to as a sample (A) (Example 5). On the other hand, the remaining samples were subsequently printed with a paste containing boron oxide and silica over the entire surface and backed at 700°C for 30 minutes. The completed sample is referred to as a sample (B) (Example 6).

Subsequently, these samples were put in an annealing furnace and held at 980°C for 10 minutes, and then taken out. Next, as shown in FIG. 2(a), junction isolation was performed with a plasma etcher, after which phosphosilicate or borosilicate glass on the surface was etched with a hydrofluoric acid.

After that, a direct plasma CVD equipment was used to deposit a nitride film with the thickness of 85 nm on both sides. Next, an Ag-contained electrode paste was printed in proper alignment with the high-concentration diffusion layers on both sides by a screen printing equipment with an alignment mechanism to thereby form a comb-like electrode pattern. The electrode paste was dried and then subjected to firing in accordance with a predetermined heat profile to thereby manufacture a solar cell as shown in FIGS. 6(a) and 6(b).

Under such conditions that each of the manufactured 15-cm square solar cells was placed under an atmosphere at 25°C, current-voltage characteristics were measured with a solar simulator (light intensity: 1 kW/m², spectrum: AM 1.5 global illuminance). Table 3 shows various characteristics of the solar cells of Examples 5 and 6 and the solar cell of Example 1.

**[Table 3]**

| | Open-circuit voltage (V) | Short-circuit current density (mA/cm²) | Conversion efficiency (%) | Fill factor |
|---|---|---|---|---|
| Example 5 Sample (A) | 0.644 | 37.3 | 18.9 | 0.786 |
| Example 6 Sample (B) | 0.641 | 37.8 | 19.2 | 0.793 |
| Example 1 | 0.635 | 37.0 | 18.5 | 0.788 |

In these examples, an area of the high-concentration BSF layer is limited to only a region just below the contact, not the entire surface. As a result, an open-circuit voltage was considerably increased as compared with Example 1. Further, a short-circuit current was increased because an amount of light absorption near the back side was reduced. Further, a grid electrode was formed on the back side, so the substrate's warp was reduced. This means that a thin cell can be easily achieved.

Incidentally, the above embodiments are not limitative but rather illustrative of the present invention, and any modifications that are made on the basis of substantially the same idea as the technical idea described in the scope of claims and attain similar advantages are encompassed within the technical idea of the present invention.

## Claims

1. A method for manufacturing a solar cell by forming a pn junction in a semiconductor substrate having a first conductivity type, comprising at least:
applying a first coating material containing a dopant onto the semiconductor substrate having the first conductivity type; and
performing vapor-phase diffusion heat treatment to form a first diffusion layer in a region applied with the first coating material and a second diffusion layer, which is formed next to the first diffusion layer through vapor-phase diffusion, with a conductivity lower than a conductivity of the first diffusion layer at the same time.

2. A method for manufacturing a solar cell by forming a pn junction in a semiconductor substrate having a first conductivity type, comprising at least:
applying a second coating material containing a dopant onto the semiconductor substrate having the first conductivity type; and
performing vapor-phase diffusion heat treatment to form a second diffusion layer in a region applied with the second coating material and a first diffusion layer, which is formed next to the second diffusion layer through vapor-phase diffusion, with a conductivity higher than a conductivity of the second diffusion layer at the same time.

3. The method for manufacturing a solar cell according to claim 1 or 2, wherein the first coating material or the second coating material contains a silicon compound.

4. The method for manufacturing a solar cell according to claim 3, wherein the silicon compound is silica gel or a precursor of silicon oxide.

5. The method for manufacturing a solar cell according to any one of claims 1 to 4, wherein a third coating material containing a silicon compound is applied over the first coating material or the second coating material and then the diffusion heat treatment is performed.

6. The method for manufacturing a solar cell according to any one of claims 1 to 5, wherein a surface of a diffusion layer formed through the diffusion heat treatment is etched back.

7. The method for manufacturing a solar cell according to any one of claims 1 to 6, wherein a surface of a diffusion layer formed through the diffusion heat treatment is oxidized.

8. The method for manufacturing a solar cell according to any one of claims 1 to 7, wherein the first diffusion layer and the second diffusion layer are formed on at least one of a light-receiving surface of the semiconductor substrate and a back side of the light-receiving surface.

9. A solar cell manufactured with the manufacturing method according to any one of claims 1 to 8, comprising:
the first diffusion layer having a conductivity type opposite to the first conductivity type of the semiconductor substrate; and
the second diffusion layer with a conductivity lower than a conductivity of the first diffusion layer having the opposite conductivity type,
the first diffusion layer and the second diffusion layer being formed on a light-receiving surface of the semiconductor substrate.

10. The solar cell according to claim 9, further comprising a diffusion layer having the at least same conductivity type as the first conductivity type, the diffusion layer being formed on a back side of the light-receiving surface.
